# EUROPEAN PATENT SPECIFICATION

(11) **EP 1 782 544 B1**
(45) Date of publication and mention of the grant of the patent: **19.11.2008**
(21) Application number: 05771704.3
(22) Date of filing: 14.07.2005
(51) Int. Cl.: H04B 1/04, H04B 7/185, H03F 3/21

(54) **HIGH POWER PARALLEL BLOCK-UP CONVERTER**
HOCHLEISTUNGS-PARALLEL-BLOCK-UP-UMSETZER
CONVERTISSEUR ELEVATEUR DE FREQUENCE PARALLELE HAUTE PUISSANCE

(30) Priority: 05.08.2004 US 598937 P; 03.12.2004 US 4488
(43) Date of publication of application: 09.05.2007
(73) Proprietor: U.S. Monolithics, L.L.C., Chandler, AZ 85225 (US)
(72) Inventor: BUER, Kenneth, V., Gilbert, AZ 85296 (US); LOPEZ, Noel, Phoenix, AZ 85004 (US); WACHTER, Friedhelm, Phoenix, AZ 85048 (US)
(74) Representative: Curley, Donnacha John
(86) International application number: PCT/US2005/025064
(87) International publication number: WO 2006/019959

(56) References cited:
- WO-A-20/04025845
- US-A- 3 845 392
- US-A- 5 838 201
- US-A- 6 049 707

## Description

### Field of the Invention

The present invention relates to communication devices, and in particular, to communication devices including a plurality of transceivers, transmitters and/or block-up converters.

### Background of the Invention

Communication devices employing transceivers, transmitters and/or block-up converters (BUCs) often send and/or receive communication signals from, for example, satellites, communication towers and the like. Communication signals are often required to travel a long distance between a sending communication device and a receiving communication device. To traverse these long distances without signal degradation, communication signals are many times converted to frequencies more conducive to efficient transmittal. For example, radio frequency (RF) signals are much easier to transmit over long distances than intermediate frequency (IF) signals. Thus, IF signals are often converted to RF signals prior to transmittal, transmitted and then converted back to IF signals once the signal reaches its destination. In addition, when transmitting signals over long distances, the signals are often amplified. However, amplifying signals generally involves significant amounts of power and is expensive. Thus, to efficiently and accurately transmit communication signals, communication devices generally convert signals from one frequency to another, and transmitting communication devices often amplify signals prior to transmission.

Existing communication devices are generally capable of converting signals from one frequency to another and have power amplification capabilities. However, existing devices employ expensive power amplification means. For example, existing communication devices utilize expensive high-power BUCs, transceivers or transmitters, or lower-power BUCs transceivers or transmitters used in conjunction with an expensive power amplifier to sufficiently amplify communication signals. In addition, these communication devices are often specially designed and/or manufactured to accomplish their objectives. Thus, a need exists for a less expensive alternative to existing communication devices without the need for special designs and/or manufacturing.

US6049707 discloses an amplifier system for transmitting wideband multicarrier communication signals in a satellite communication system uses wideband envelope elimination and restoration amplifiers. The system upconverts channelized IF signals to provide a wideband multicarrier RF output signal between 20 and 30 GHz having a bandwidth between 100 and 200 MHz.

US5838201 discloses a solid state power amplifier which combines the output of several power modules by means of a waveguide radial combiner. The physical structure of the amplifier is such that the power modules lay flat on a planar heat sink which can be easily cooled by forced air. The input power can be distributed to the power modules by means of a microstrip divider. The divider can be connected to the modules by means of coaxial cables and the modules can be connected to the radial combiner by means of microstrip to waveguide transitions.

### Summary of the Invention

The present invention provides a system and method as claimed in the independent claims. Advantageous embodiments and features are set forth in the dependent claims.

### Brief Description of the Drawings

Figure 1 is an illustration of an exemplary embodiment of a communication device configured to transmit and/or receive wireless communication signals.
Figure 2 is a bottom view of the communication device illustrated in Figure 1.
Figure 3 is a forward view of the communication device illustrated in Figure 1.
Figure 4 is a side view of the communication device illustrated in Figure 1.
Figure 5 is a block diagram of an exemplary communication device including two block-up converter devices.
Figure 6 is a block diagram of an exemplary communication device including N block-up converter devices.
Figure 7 is a schematic diagram of a first exemplary embodiment of a signal splitter.
Figure 8 is a schematic diagram of a second exemplary embodiment of a signal splitter.
Figure 9 is a flow diagram illustrating an exemplary embodiment of a method to amplify, convert and transmit communication signals from a first communication device to a second communication device.

### Detailed Description of tire invention

In accordance with one aspect the present invention, a communication device, methods and systems facilitate increased power transmission signals at reduced cost. The transmissions, in one exemplary embodiment, may be wireless transmissions. In other examples, the transmissions may be a non-wireless type of transmissions. For example, the transmissions may occur over a cable based transmission system. In accordance with yet other aspects, the communication device, methods and systems facilitate improved reliability, and/or faster time-to-market of transmission devices.

Thus, in accordance with an exemplary embodiment of the present invention, two or more block up-converters (BUCs) are combined in parallel, wherein the total output power of the combination is approximately equal to the combined power of the two or more BUCs. In another example, two or more transceivers are combined in parallel, wherein the total output power of the combination is approximately equal to the combined power of the two or more transceivers. The BUCs and/or transceivers may be "off the shelf' items, thus greatly reducing design costs. Furthermore, the combined total cost of the BUCs and/or transceivers may be less than the cost of a single BUC or transceiver configured to achieve the same output power as the combination.

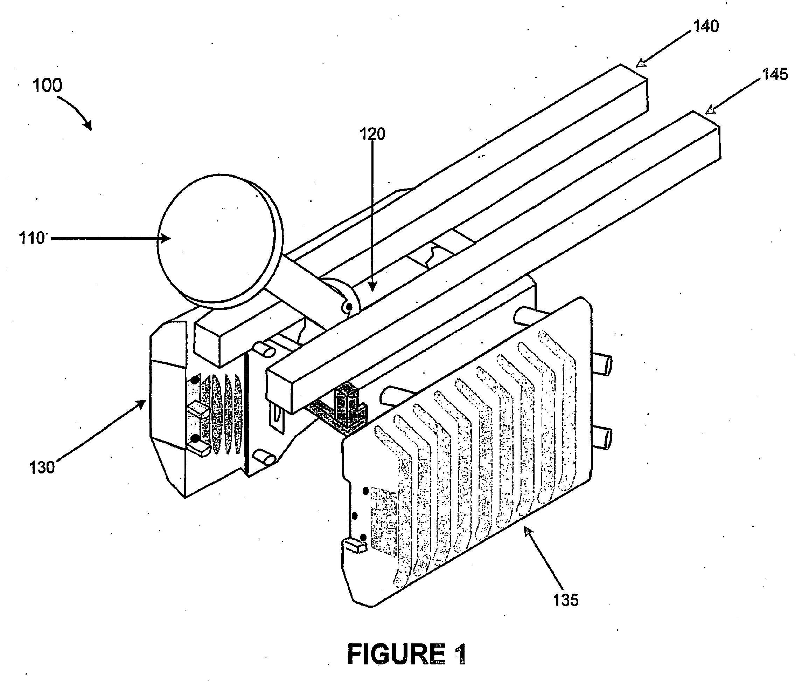

Figure 1 is an illustration of an exemplary embodiment of a communication device 100 configured to transmit and/or receive wireless communication signals. Communication device 100, in one embodiment, includes an antenna configured to facilitate the transmission of communication signals to and/or from communication device 100. The communication signals are transmitted between communication device 100 and other external communication devices (not shown).

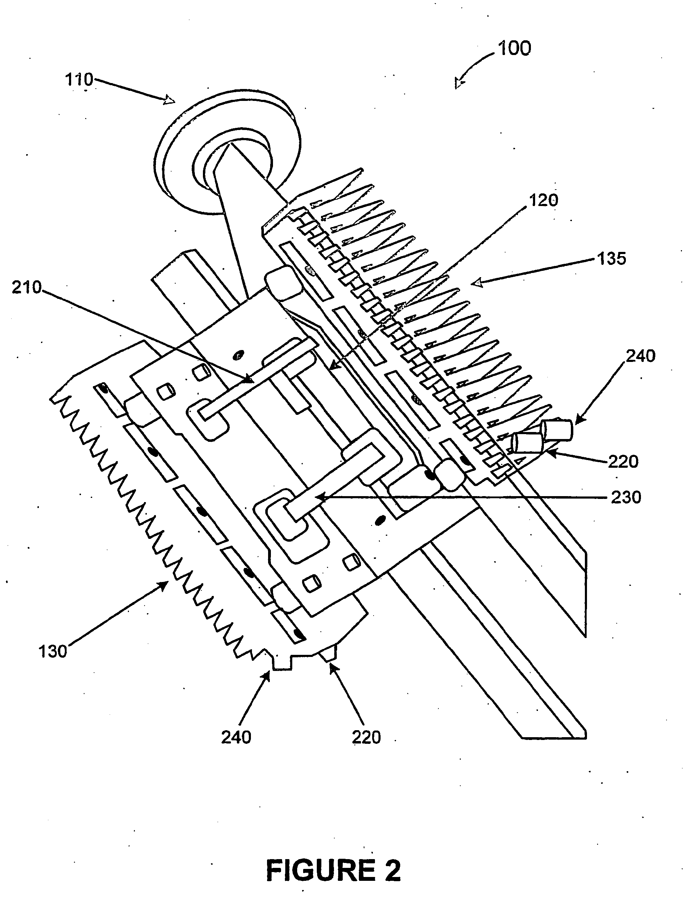

In accordance with one exemplary embodiment of the present invention, communication device 100 may include a first transceiver 130, a second transceiver 135, an orthogonal mode transducer (OMT) 120 and a waveguide combiner 210 (shown in Figure 2). The first and second transceivers may be configured in parallel to each other and connected to OMT 120 and waveguide combiner 210. Communication device 100 may further include an antenna connected to OMT 120. Although various antennas may be used in connection with communication device 100, in one exemplary embodiment, the antenna is a feed horn 110.

In one exemplary embodiment, feed horn 110 is manufactured by Raven Manufacturing of Blackborne UK. In other embodiments, feed horn 110 may be any feed horn device or antenna known in the art.

Connected to feed horn 110, in an exemplary embodiment, is orthogonal mode transducer (OMT) 120. In one embodiment, OMT 120 is a transducer configured to transfer radio frequency (RF) signals to individual ports (e.g., a transmission port and/or a receiving port) and to provide an isolation between at least two orthogonal planes (e.g. vertical plane and horizontal plane). For example, OMT 120 may be an OMT manufactured by Raven Manufacturing of Blackborne UK. In other embodiments, OMT 120 may be any OMT device known in the art.

Communication device 100, in one embodiment, may also include transceiver 130 and transceiver 135. Transceivers 130 and 135 may be, directly or indirectly, connected to OMT 120. In one embodiment, with reference to Figure 1, transceivers 130 and 135 may each receive a group of data bits or a modulated IF carrier transmitted as a unit to communication device 100 and translate the frequencies such that the output frequencies and power of the signals from transceivers 130 and 135 are higher than the input frequency. In other words, transceivers 130 and 135 may up-convert and amplify the power of signals received by them.

In one exemplary embodiment, transceivers 130 and 135 are each S to Ka-band transceiver devices. In other embodiments, transceivers 130 and 135 are Ku-band, S-Band, K-band, C-band, X-band, or any other frequency band or signal type transceiver devices.

Transceivers 130 and 135, in an exemplary embodiment, are two watt transceiver devices. In other embodiments, transceivers 130 and 135 are in the range of about 0.25 watts to about 10 watts each. Therefore, connecting two or more transceivers of two watt power may result in a less expensive communication device than a communication device employing a single four watt transceiver. In addition, it will be appreciated that the complexity, cost and/or design difficulty for transceivers may vary depending on many factors. For example, as operating frequencies increase, often the complexity, cost and/or design difficulty may increase unless the power is reduced. Thus, the transceivers of the present invention may be of any power level where it is advantageous to couple two transceivers in parallel. By way of example, combining two or more transceivers in parallel may be advantageous for high power, high frequency transceiver devices. For example, coupling two transceivers in parallel may provide a cost and/or design time advantage for relatively high power transceivers.

In one embodiment, transceivers 130 and 135 are of equal size. For example, transceivers 130 and 135 may each be two watt transceiver devices. In other embodiments, transceiver 130 may have a different power level than transceiver 135. For example, transceiver 130 may be a one watt transceiver, while transceiver 135 may be a two watt transceiver.

As described above, communication device 100 may include two transceivers. In addition, communication device 100 may include more than two transceiver devices. In an exemplary embodiment, each of the plurality of N transceivers may be the same size. Moreover, it is contemplated that communication device 100 may include different sized transceivers such that each transceiver device has a different wattage or at least two of the plurality of N transceivers have different wattages.

Communication device 100, in another exemplary embodiment, includes two or more transceiver devices to take advantage of the economies of scale of producing a transceiver of a single size (e.g., one power level) to accomplish a desired increase in power without using a specially manufactured power amplifier for each desired, different possible configuration of communication device 100. For example, it may be more cost efficient to produce five one-watt transceivers and include, for example, three one-watt transceivers for communication device A and two one-watt transceivers on communication device B rather than designing and manufacturing a single three-watt transceiver for communication device A and a single two-watt transceiver for communication device B. Furthermore, it may be advantageous to use five one-watt transceivers rather than using a one-watt transceiver in conjunction with a specially designed power amplifier (a five times power amplifier in this example).

Although described herein in connection with transceivers connected in parallel, the same technique can be applied to create systems, methods and devices with BUCs that are connected in parallel. Transceivers and/or BUCs of higher power and/or frequency tend to cost significantly more and/or disproportionately more than transceivers and/or BUCs of relatively lower power and/or frequency. For example, three one-watt BUC devices may be cheaper to manufacture and/or purchase than one three-watt BUC device and/or a one-watt BUC device used in conjunction with a power amplifier (a three times power amplifier in this example).

Furthermore, design costs may also contribute to the typically greater cost of producing higher power devices. Also, economies of scale may help absorb the design costs of devices that are sold in relatively greater quantities, such as, for example, lower power devices. Therefore, it may be more cost effective to use several lower power transceiver and/or BUC devices connected in parallel than it is to use one large transceiver and/or BUC device. It may also be more cost effective to use several lower power transceivers and/or BUC devices connected in parallel than it is to use a small transceiver and/or BUC device in conjunction with a power amplifier.

Also, communication device 100 may be configured to enhance reliability. For example, having two or more transceiver / BUC devices may enhance the reliability to communication device 100. Reliability may be increased due to redundancy of components, whereby instead of a complete loss of a transmitted signal, the transceiver and/or BUC device may continue to transmit with a signal that may be slightly degraded. For example, the signal may be degraded by just a few dB. Thus, in exemplary embodiments of the present invention, the transceivers and/or BUCs connected in parallel are redundant.

In accordance with an exemplary embodiment, communication device 100 may be a transceiver manufactured by U.S. Monolithics of Gilbert, Arizona, such as Model # USM-TXR-Kal-3W-f-01-120. Furthermore, communication device 100 may be a BUC device manufactured by NJRC of Japan, such as Model #'s NJT5018F, NJT5017F, and/or NJT5656F. In addition, communication device 100 may include any BUC and/or transceiver known in the art, such as, for example, devices operating in accordance with the 802.11 "WiFi" or "WiMax" standards. Furthermore, communication device 100 may include similar components for non-wireless communication. For example, communication device 100 may include a CATV network, a telephone network and/or any other cable transmission that may require frequency conversion and higher power due to long distance transmission.

In one embodiment, communication device 100 includes boom arm 140 and boom arm 145. Boom arms 140, 145 may be configured to couple communication device 100 to any suitable support structure. Boom arms 140, 145 may be configured, for example, to orient communication device 100 in a manner to allow an antenna (e.g., feed horn 110) to receive and/or send a communication signal to and/or from an external communication device. In one embodiment, boom arms 140, 145 are made of steel. In other embodiments, boom arms 140, 145 may be made of any material suitable for supporting communication device 100. Although, in the embodiment shown in Figure 1, communication device 100 includes two boom arms, it is contemplated that communication device 100 may comprise only one boom arm or more than two boom arms.

Figure 2 is a bottom view of communication device 100 discussed above with respect to Figure 1. As illustrated in Figure 2, communication device 100, in one embodiment, includes waveguide combiner 210 connected to transceivers 130 and 135. Waveguide combiner 210, in an exemplary embodiment, may comprise any signal combining device or other junction capable of combining two or more amplified RF signals from two or more transceivers into a single, amplified RF signal. In an exemplary embodiment, waveguide combiner 210 is a magic-T type waveguide combiner. In the embodiment shown in Figure 2, waveguide combiner 210 receives a RF signal from each of transceivers 130, 135, respectively, combines the two signals into a single, amplified signal and sends the combined signal to OMT 120, which transfers the single, amplified signal to an antenna (e.g., feed horn 110) to be transmitted to an external communication device.

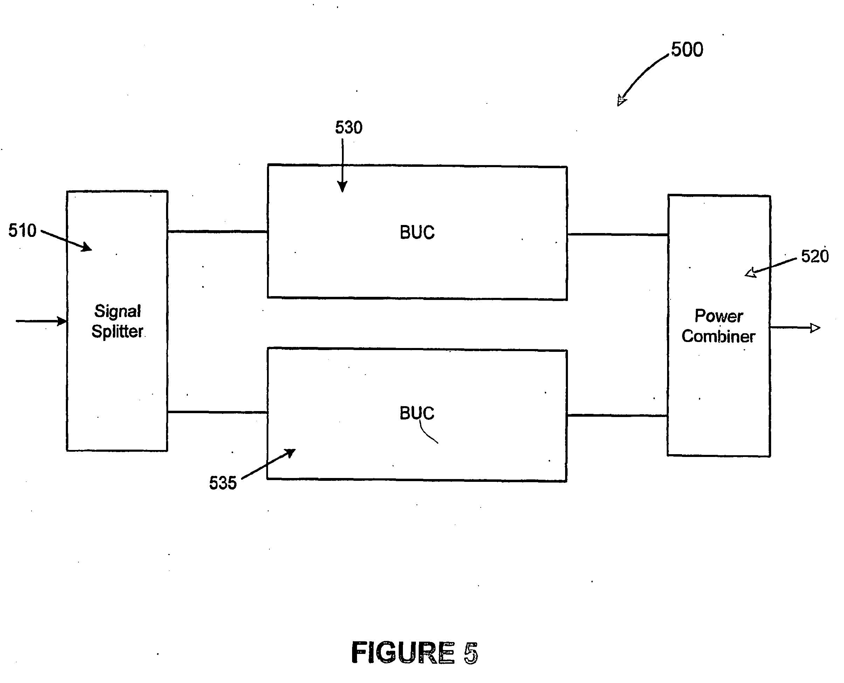

In one embodiment, transceivers 130 and 135 each receive an intermediate frequency (IF) signal from a signal splitter (not shown, but discussed below with respect to Figure 5) at TX connection 220. Transceivers 130 and 135 may then each convert their received IF signal to an RF signal and each, respectively, amplify their RF signal before sending the signals to waveguide combiner 210.

Communication device 100, in an exemplary embodiment, includes receiving junction 230 connected to an antenna and at least one transceiver device. In the embodiment shown in Figure 2, receiving junction 230 is connected to OMT 120 and transceiver 130. In addition, in other embodiments, receiving junction 230 could also be connected to transceiver 135 or any other transceiver or receiving device that may be included in communication device 100.

Receiving junction 230, in the embodiment shown in Figure 2, receives an RF signal from an antenna (e.g., feed horn 110) and sends the signal to OMT 120, and OMT 120 sends the signal to transceiver 130. In an exemplary embodiment, transceiver 130 converts the RF signal to an IF signal and may either amplify or reduce the signal before sending the signal to an IF receiver (not shown) connected to communication device 100 via RX connection 240.

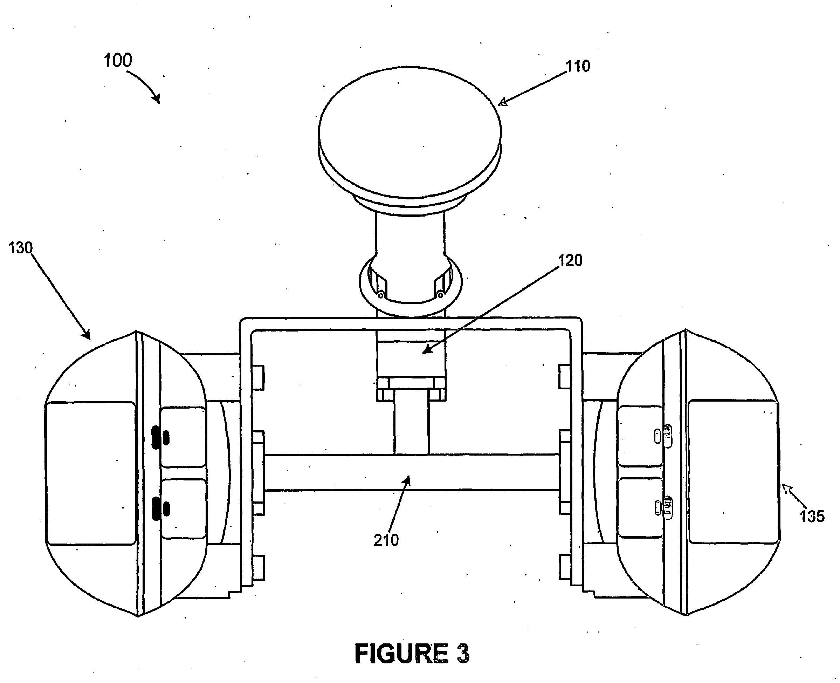

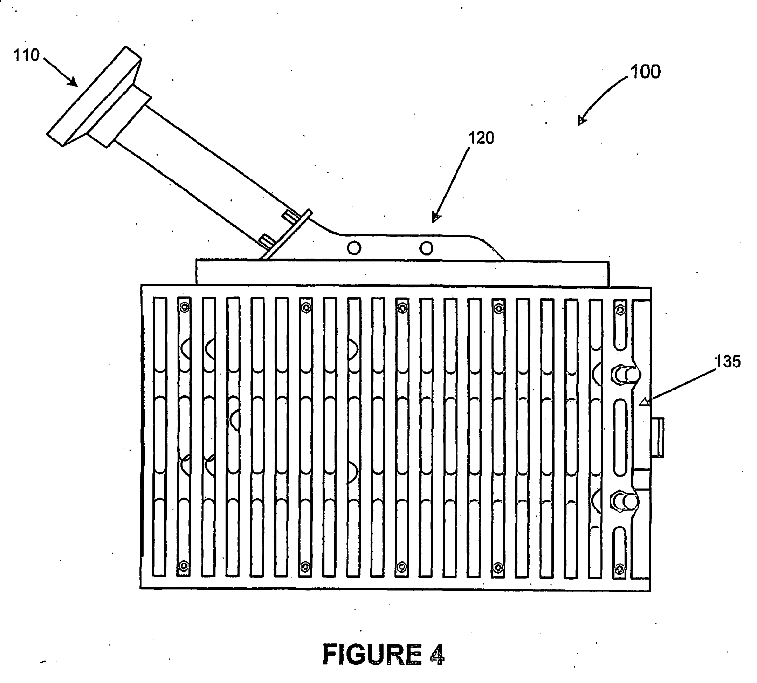

Figures 3 and 4 are a forward view and side view, respectively, of exemplary communication device 100 discussed above in Figures 1 and 2. In the embodiments shown in Figures 3 and 4, exemplary relative positioning of horn feed 110, OMT 120, waveguide combiner 210, and transceivers 130 and 135 is illustrated. In addition, it is contemplated that these components may be positioned in other suitable orientations to achieve the designs of the present communication device.

Figure 5 is a block diagram of an exemplary communication device 500. Communications device 500 may comprise, for example, a signal splitter 510, two or more BUCs 530 and 535, and a power combiner 520. Signal splitter 510 may be any suitable signal splitter. For example, signal splitter 510 may configured to split an IF signal into two or more IF signals, split a reference signal into two or more reference signals, and/or split a direct current (DC) signal into two or more DC signals. Signal splitter 510 may be further configured to send one of each of the plurality of split IF signals, plurality of split reference signals, and/or plurality of split DC signals to each of the two or more BUC devices (e.g., BUCs 530 and 535) that are connected to signal splitter 510. The DC signal, in an exemplary embodiment, serves to provide power to each of BUCs 530 and 535, respectively.

Signal splitter 510, in one embodiment, splits an incoming IF signal into two or more IF signals and then sends one of the IF signals to each of two or more BUC devices (e.g., BUCs 530 and 535) that are connected to signal splitter 510. Likewise, in one embodiment, signal splitter 510 may perform the function of splitting an incoming reference signal into two or more reference output signals. Also, signal splitter 510 may be configured to split an incoming DC signal into two or more DC signals. These split signals may be communicated to the plurality of BUC devices connected, directly or indirectly, to signal splitter 510. In one exemplary embodiment, splitter 510 performs all three of the splitting functions; namely: DC, reference, and IF signal splitting. In this regard, the signals are multiplexed onto a single cable connection (e.g., per BUC) for simplicity of installation and reduced cable costs. In addition, in other embodiments, the DC power and/or the reference signal may be separately provided to BUCs 530 and 535, for example, through another connector.

BUCs 530 and 535, in an exemplary embodiment, each receive a single IF signal, a single reference signal and a single DC signal from signal splitter 510. Furthermore, BUCs 530 and 535 may be configured to convert their received IF signal to an RF signal and amplify their respective signal. In one exemplary embodiment, a local oscillator signal in each of BUCs 530 and 535 is produced by a digital phase-lock loop (not shown) which is locked to the same reference signal such that the local oscillator signals inside each of BUCs 530 and 535 have the same phase and/or each of the transceivers have the same phase.

In accordance with another exemplary embodiment, the same local oscillator is fed directly to BUCs 530 and 535 and/or each transceiver. Furthermore, other systems for synchronizing the phase of the local oscillators may also be used. For example, an analog phase lock loop may be configured to synchronize the phase in BUCs 530 and 535. In accordance with another aspect of the present invention, synchronization of the local oscillator phase may facilitate power savings. For example, if the up-convert function is performed without a phase locked or synchronized local oscillator, then the output of BUCs 530 and 535 may be combined with different phases and thus power may be lost.

In one embodiment, once the IF signal has been converted to an RF signal and the RF signal is amplified in each of BUCs 530 and 535, each amplified RF signal is communicated from BUCs 530 and 535 to power combiner 520. Power combiner 520 may include, for example, an in-phase waveguide combiner. Power combiner 520, in one embodiment, is a magic-T similar to the embodiments discussed above with respect to Figure 2.

In the exemplary embodiment shown in Figure 5, the plurality of amplified RF signals received by power combiner 520 are combined to produce a single, higher power communication signal. In one embodiment, the single higher power signal is communicated to an OMT (e.g., OMT 120), then to an antenna (e.g., feed horn 110) before being transmitted to an external communication device.

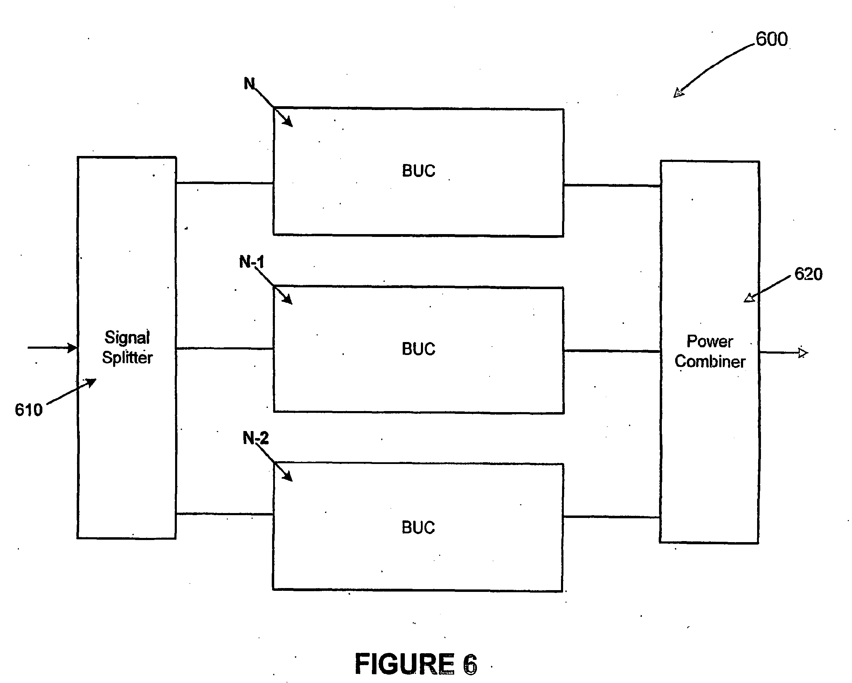

Figure 6 is a block diagram of an exemplary communication device 600. Communications device 600 may comprise, for example, N BUC devices (or N transceivers). Communication device 600 may operate similar to communication device 100 discussed above with respect to Figures 1-5 with particular attention to the discussion regarding Figure 5 except that signal splitter 610 may be configured to split the incoming signal into n IF signals, N reference signals, and/or N DC signals and send the N signals (or N groups of signals) to N different BUC devices to be converted into N amplified RF signals that are to be combined, by combiner 620, into a single amplified RF signal that may be communicated to an antenna.

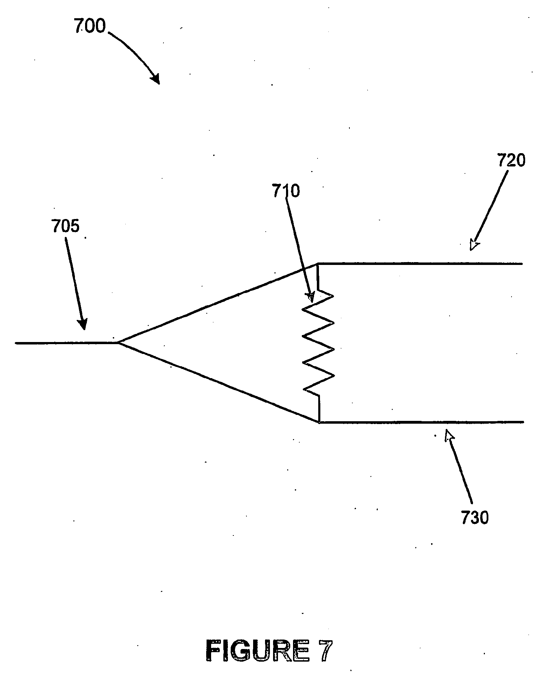

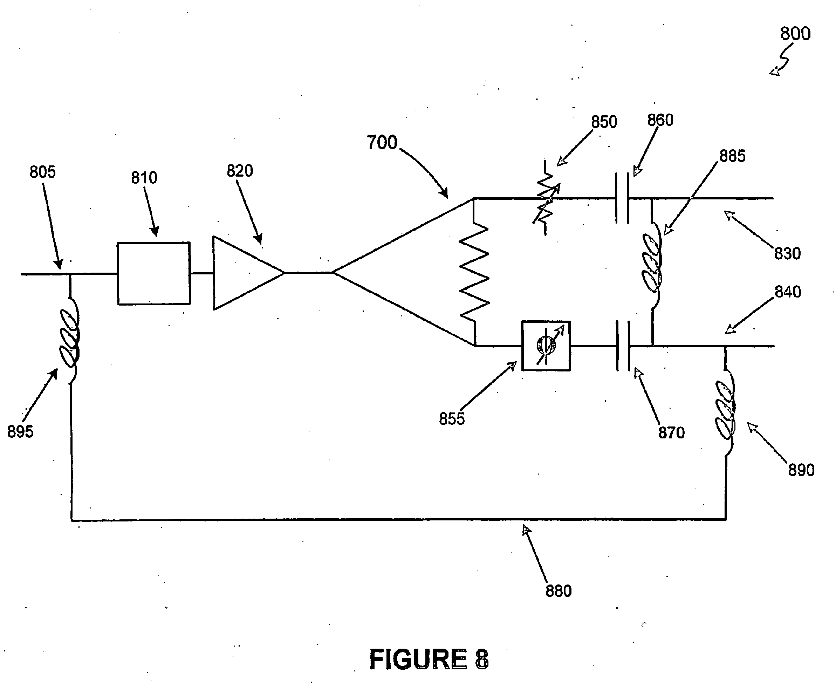

Figures 7 and 8 are schematic diagrams of exemplary embodiments of signal splitter 700 and signal splitter 800. Signal splitters 700 and 800 may be used in connection with parallel transceivers and/or parallel BUCs. With reference to Figure 7, signal splitter 700 may be a simple signal splitter that is configured to split a DC signal, a reference signal, and an IF signal entering signal splitter 700 at input 705. Signal splitter 700 may include a resistive element 710 between output 720 and output 730. Signal splitter 700 may be useful in applications where the phase and amplitude balance are adequately matched, reducing the need for further alignment. In particular, in some digital applications, communication devices (e.g., communication device 100) may automatically synchronize or phase lock, facilitating use of a simple signal splitter, such as signal splitter 700. In one exemplary embodiment, signal splitter 700 may be, for example, a standard Wilkinson type signal splitter.

With reference to Figure 8, signal splitter 800 may be configured to work in applications where the phase and amplitude balance is not adequately matched and further alignment is desired. For example, signal splitter 800 may include an input 805, a high pass filter 810, an amplifier 820, and/or a standard signal splitter 700 (e.g., a Wilkinson type signal splitter). High pass filter 810, amplifier 820 and signal splitter 700 may be any high pass filter, amplifier or signal splitter capable of being used within signal splitter 800.

Output 830 and output 840 of signal splitter 700 may be connected to a variable attenuator 850 for amplitude adjustment and/or a variable phase shifter 855 for phase adjustment. Outputs 830 and 840 may also each be connected to a capacitor 860 and a capacitor 870, respectively, and/or an inductor 885, and/or a DC reference path 880. The DC reference path 880 may include one or more inductors on it.

In the exemplary embodiment shown in Figure 8, outputs 830 and 840 may have an inductor 885 connected between them, and output 840 may be additionally connected to DC reference path 880, in which DC reference path may include inductors 890 and 895. With the type of signal splitter 800 illustrated in Figure 8, two non-identical BUCs that operate in the same frequency band may be connected and the split input adjusted appropriately.

Thus, in one exemplary embodiment, transceivers may be designed to achieve X watts by dividing X watts by an even integer Y and using Y transceivers of X/Y watts to achieve X watts of transmission power. Although power amps have been designed in parallel to achieve higher power, these designs generally involve significant changes to the transceiver circuitry. In contrast, in accordance with the present invention, existing and/or simple transmitters/BUC's may be combined in parallel to achieve a desired output power without redesigning the transmitters/BUC's themselves.

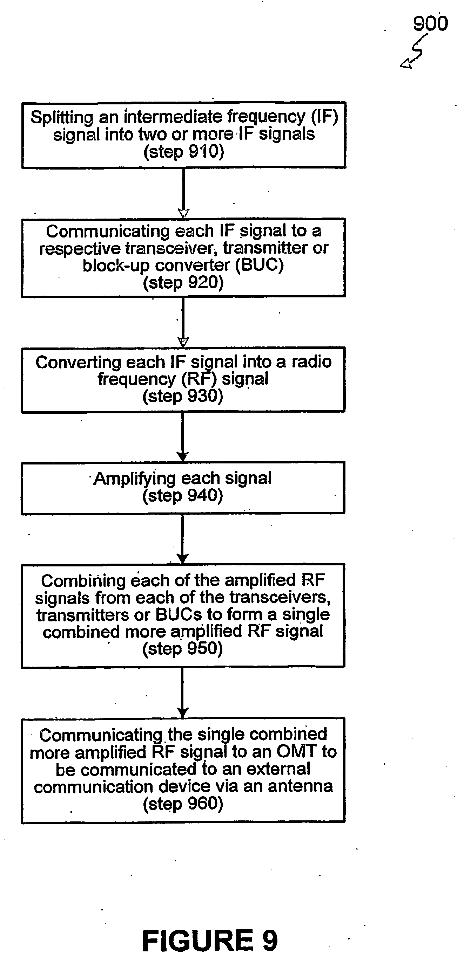

With reference now to Figure 9, a communication method 900 may comprise the steps of splitting an IF signal into two or more IF signals (step 910), communicating the split IF signals to two or more transceivers, transmitters or BUCs that are functionally in parallel with each other (step 920), and converting the split IF signals into RF signals (step 930). Method 900 may also include amplifying the signals (step 930). The signals being amplified may be the IF signals, the RF signals, or both the IF and RF signals. In one exemplary embodiment, the signals may be amplified utilizing a transceiver, transmitter and/or BUC. As such, the two or more signals eventually form two or more amplified RF signals when leaving their respective transceiver, transmitter and/or BUC. After the two or more amplified RF signals are formed, method 900 may also include combining each of the amplified RF signals from the two or more transceivers, transmitters or BUCs to form a single combined, more amplified RF signal (step 950). Method 900 may further include the step of communicating the single combined, more amplified RF signal to an OMT to be communicated to an external communication device via an antenna (step 960).

Various embodiments employing BUC devices and transceivers have been disclosed herein. In addition, in other exemplary embodiments, similar techniques may be used where transmitters are used in place of the BUCs and/or the transceivers described herein and similar results may be obtained. Moreover, although described herein as a digital transceivers, BUCs and transmitters, the methods, techniques and systems may also be used for analog transceivers, BUCs and/or transmitters. Likewise, a method of building a transmitting device may comprise the steps of connecting two or more transmitters/BUCs in parallel, connecting a signal splitter to the input of the two or more transmitters/BUCs, and connecting a signal combiner to the two or more transmitters/BUCs.

Benefits, advantages and solutions to problems have been described herein with regard to specific embodiments. However, the benefits, advantages, solutions to problems, and any element(s) that may cause any benefit, advantage, or solution to occur or become more pronounced are not to be construed as critical, required, or essential features or elements of the invention. As used herein, the terms "comprises", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus. Further, no element described herein is required for the practice of the invention unless expressly described as "essential" or "critical".

## Claims

1. A communication device (500), comprising:
a first element (530);
a second element (535) coupled in parallel to said first element, said first element and said second element are respectively configured to upconvert and amplify a first element input communication signal and a second element input communication signal **characterised in that** the device further comprises a signal splitter (510) coupled to said first element and said second element, wherein said signal splitter is configured to split a communication signal entering said signal splitter into said first element input communication signal and said second element input communication signal where the first and second communication signals are the same frequency, and wherein said first element input communication signal is communicated to said first element, and said second element input communication signal is communicated to said second element; and
a waveguide combiner (520) coupled to said first element and said second element,
wherein said waveguide combiner is configured to combine a first upconverted and amplified communication signal from said first element and a second upconverted and amplified communication signal from said second element to form a combined communication signal, said combined communication signal to be communicated to an external communication device, wherein said first and second elements are both a transceiver, a block-up converter or a transmitter.

2. The communication device of claim 1, wherein said first element (530) and said second element (535) are the same size.

3. The communication device of claim 1, wherein said first element (530) and said second element (535) are different sizes.

4. The communication device of claim 2 or claim 3, wherein said first element (530) and said second element (535) are each in the range of about 0.25 watts to about 10 watts.

5. The communication device of claim 1, further comprising: an antenna coupled to said waveguide combiner, wherein said antenna is configured to send said combined communication signal to said external communication device.

6. The communication device of claim 5, wherein said antenna is a feed horn.

7. The communication device of claim 1 wherein said communication signals are wireless signals.

8. The communication device of claim 7, wherein said wireless signals are radio frequency (RF) signals.

9. The communication device of claim 1, wherein said first element input communication signal and said second element input communication signal are similar signals.

10. The communication device of claim 1, wherein said first element and said second element are one of Ka-band, Ku-band, S-band, C-band and X-band elements.

11. The communication device of claim 1, wherein said waveguide combiner is a magic-T waveguide combiner.

12. The communication device of claim 1, further comprising:
an orthogonal mode transducer (OMT) coupled to at least one of said first element, said second element and said waveguide combiner, wherein said OMT is configured to:
receive a communication signal from an antenna and transmit said received signal to at least one of said first element and said second element; and
receive said combined communication signal from said waveguide combiner and transmit said combined communication signal to said antenna.

13. A method of amplifying communication signals, **characterised in that** the method comprises the steps of:
splitting (910) a first communication signal, wherein said split first communication signal comprises a second communication signal and a third communication signal where the second communication signal and third communication signal are the same frequency;
communicating (920) said second communication signal to one of a first transceiver and a first transmitter;
communicating (920) said third communication signal to one of a second transceiver and a second transmitter;
upconverting and amplifying (940) said second communication signal utilizing one of said first transceiver and said first transmitter to comprise a first amplified communication signal;
upconverting and amplifying (940) said third communication signal utilizing one of said second transceiver and second transmitter to comprise a second amplified communication signal; and
combining (950) said first amplified communication signal and said second amplified communication signal.

14. The method of claim 13, wherein amplifying said second communication signal utilizing one said first transceiver and said first transmitter comprises the steps of:
communicating said second communication signal to a first block up-converter (BUC) within one of said first transceiver and first transmitter; and
amplifying said third communication signal utilizing one of said second transceiver and said second transmitter comprises communicating said third communication signal to a second BUC within one of said second transceiver and said second transmitter.

15. The method of claim 13, where the combining step provides a high power, high frequency communication signal.

16. The method of claim 15, further comprising the step of:
communicating said higher power communication signal to an external communication device and/or communicating said higher frequency communication signal to an external communication device.

## Patentansprüche

1. Kommunikationsvorrichtung (500), welche enthält:
ein erstes Element (530);
ein zweites Element (535), welches parallel zu dem ersten Element gekoppelt ist, wobei das erste Element und das zweite Element jeweils dazu konfiguriert sind, ein Eingabe-Kommunikationssignal des ersten Elements und ein Eingabe-Kommunikationssignal des zweiten Elements herauf umzuwandeln und zu verstärken, **dadurch gekennzeichnet, dass** die Vorrichtung ferner einen Signal-Splitter (510) enthält, welcher an das erste Element und das zweite Element gekoppelt ist, wobei der Signal-Splitter dazu konfiguriert ist, ein Kommunikationssignal, welches in den Signal-Splitter eintritt, in das Eingabe-Kommunikationssignal des ersten Elements und das Eingabe-Kommunikationssignal des zweiten Elements aufzuteilen, wobei das erste und zweite Kommunikationssignal die gleiche Frequenz haben, und wobei das Eingabe-Kommunikationssignal des ersten Elements an das erste Element kommuniziert wird und das Eingabe-Kommunikationssignal des zweiten Elements an das zweite Element kommuniziert wird; und
einen Wellenleiter-Zusammenfasser (520), welcher an das erste Element und das zweite Element gekoppelt ist,
wobei der Wellenleiter-Zusammenfasser dazu konfiguriert ist, ein erstes herauf umgewandeltes und verstärktes Kommunikationssignal von dem ersten Element und ein zweites herauf umgewandeltes und verstärktes Kommunikationssignal von dem zweiten Element zusammenzufassen, um ein zusammengefasstes Kommunikationssignal auszubilden, wobei das zusammengefasste Kommunikationssignal an eine externe Kommunikationsvorrichtung kommuniziert wird, wobei das erste und zweite Element jeweils ein Transceiver, ein Block-Herauf-Umwandler oder ein Übertrager ist.

2. Kommunikationsvorrichtung nach Anspruch 1, bei welcher das erste Element (530) und das zweite Element (535) von der gleichen Größe sind.

3. Kommunikationsvorrichtung nach Anspruch 1, bei welcher das erste Element (530) und das zweite Element (535) von unterschiedlicher Größe sind.

4. Kommunikationsvorrichtung nach Anspruch 2 oder 3, bei welcher das erste Element (530) und das zweite Element (535) jeweils in einem Bereich von etwa 0,25 Watt bis etwa 10 Watt sind.

5. Kommunikationsvorrichtung nach Anspruch 1, welche ferner enthält: eine Antenne, welche an dem Wellenleiter-Zusammenfasser gekoppelt ist, wobei die Antenne dazu konfiguriert ist, um das zusammengefasste Kommunikationssignal an die externe Kommunikationsvorrichtung zu senden.

6. Kommunikationsvorrichtung nach Anspruch 5, bei welcher die Antenne ein Speisehorn ist.

7. Kommunikationsvorrichtung nach Anspruch 1, bei welcher die Kommunikationssignale gleich Drahtlos-Signale sind.

8. Kommunikationsvorrichtung nach Anspruch 7, bei welcher die Drahtlos-Signale gleich Funkfrequenz-(RF)-Signale sind.

9. Kommunikationsvorrichtung nach Anspruch 1, bei welcher das Eingabe-Kommunikationssignal des ersten Elements und das Eingabe-Kommunikationssignal des zweiten Elements ähnliche Signale sind.

10. Kommunikationsvorrichtung nach Anspruch 1, bei welcher das erste Element und das zweite Element eines aus einem Ka-Band-, Ku-Band-, S-Band-, C-Band- und X-Band-Element sind.

11. Kommunikationsvorrichtung nach Anspruch 1, bei welcher der Wellenleiter-Zusammenfasser ein Magic-T-Wellenleiter-Zusammenfasser ist.

12. Kommunikationsvorrichtung nach Anspruch 1, welche ferner enthält:
einen Orthogonal-Modus-Umformer (OMT), welcher an zumindest einem aus dem ersten Element, dem zweiten Element und dem Wellenleiter-Zusammenfasser gekoppelt ist, wobei der OMT dazu konfiguriert ist, um:
ein Kommunikationssignal von einer Antenne zu empfangen und das empfangene Signal an zumindest einen aus dem ersten Element und dem zweiten Element zu übertragen; und
das zusammengefasste Kommunikationssignal von dem Wellenleiter-Zusammenfasser zu empfangen und das zusammengefasste Kommunikationssignal an die Antenne zu übertragen.

13. Verfahren zum Verstärken von Kommunikationssignalen, **dadurch gekennzeichnet, dass** das Verfahren die Schritte enthält:
Aufteilen (910) eines ersten Kommunikationssignals, wobei das aufgeteilte erste Kommunikationssignal ein zweites Kommunikationssignal und ein drittes Kommunikationssignal enthält, wobei das zweite Kommunikationssignal und das dritte Kommunikationssignal die gleiche Frequenz haben;
Kommunizieren (920) des zweiten Kommunikationssignals an einen aus einem ersten Transceiver und einem ersten Übertrager;
Kommunizieren (920) des dritten Kommunikationssignals an einen aus einem zweiten Transceiver und einem zweiten Übertrager;
Herauf-Umwandeln und Verstärken (940) des zweiten Kommunikationssignals unter Verwendung von einem aus dem ersten Transceiver und dem ersten Übertrager, um ein erstes verstärktes Kommunikationssignal zu erhalten;
Herauf-Umwandeln und Verstärken (940) des dritten Kommunikationssignals unter Verwendung von einem aus dem zweiten Transceiver und dem zweiten Übertrager, um ein zweites verstärktes Kommunikationssignal zu erhalten; und
Zusammenfassen (950) des ersten verstärkten Kommunikationssignals und des zweiten verstärkten Kommunikationssignals.

14. Verfahren nach Anspruch 13, bei welchem das Verstärken des zweiten Kommunikationssignals unter Verwendung von einem aus dem ersten Transceiver und dem ersten Übertrager die Schritte enthält:
Kommunizieren des zweiten Kommunikationssignals an einen ersten Block-Herauf-Umwandler (BUC) innerhalb von einem aus dem ersten Transceiver und dem ersten Übertrager; und
wobei das Verstärken des dritten Kommunikationssignals unter Verwendung von einem aus dem zweiten Transceiver und dem zweiten Übertrager ein Kommunizieren des dritten Kommunikationssignals an einen zweiten BUC innerhalb von einem von dem zweiten Transceiver und dem zweiten Übertrager enthält.

15. Verfahren nach Anspruch 13, bei welchem der Zusammenfassungs-Schritt ein Hochleistungs-, Hochfrequenz-Kommunikationssignal bereitstellt.

16. Verfahren nach Anspruch 15, welches ferner den Schritt enthält:
Kommunizieren des Hochleistungs-Kommunikationssignals an eine externe Kommunikationsvorrichtung und/oder Kommunizieren des Hochfrequenz-Kommunikationssignals an eine externe Kommunikationsvorrichtung.

## Revendications

1. Dispositif de communication (500) comprenant :
- un premier élément (530) ;
- un second élément (535) connecté en parallèle audit premier élément, ledit premier élément et ledit second élément étant respectivement configurés pour assurer une conversion/élévation de fréquence et une amplification (1) d'un signal d'entrée du premier élément et un signal d'entrée du second élément, **caractérisé en ce que** le dispositif comporte également un séparateur de signal (510), connecté audit premier élément et audit second élément, ledit séparateur de signal étant configuré pour séparer un signal de communication entrant dans ledit séparateur en ledit signal d'entrée du premier élément et ledit signal d'entrée du second élément, le premier et le second signaux étant de même fréquence, et dans lequel ledit signal d'entrée du premier élément est transmis audit premier élément et ledit signal d'entrée du second élément est transmis audit second élément et ;
- un combinateur à guide d'ondes (520), relié audit premier élément et audit second élément, dans lequel ledit combinateur à guide d'ondes est configuré pour combiner un premier signal converti élevé en fréquence et amplifié à partir dudit premier élément et un second signal converti élevé en fréquence et amplifié depuis le second élément pour former un signal de communication combiné, ledit signal de communication combiné étant communiqué à un dispositif de communication externe, dans lequel lesdits premier et second éléments sont tous deux un émetteur récepteur, un convertisseur élévateur de fréquence ou un transmetteur.

2. Dispositif selon la revendication 1, dans lequel ledit premier élément (530) et ledit second élément (535) sont de même taille.

3. Dispositif selon la revendication 1, dans lequel ledit premier élément (530) et ledit second élément (535) sont de tailles différentes.

4. Dispositif de communication selon la revendication 2 ou 3, dans lequel ledit premier élément (530) et ledit second élément (535) sont chacun dans la plage d'environ 0,25 watts à environ 10 watts.

5. Dispositif de communication selon la revendication 1, qui comprend en outre une antenne reliée audit combinateur à guide d'ondes, dans laquelle ladite antenne est configurée pour envoyer ledit signal de communication combiné audit dispositif de communication externe.

6. Dispositif de communication selon la revendication 5, dans laquelle ladite antenne est un cornet d'alimentation.

7. Dispositif de communication selon la revendication 1, dans lequel lesdits signaux de communication sont des signaux sans fil.

8. Dispositif de communication selon la revendication 7, dans lequel lesdits signaux sans fil sont des signaux radiofréquences (RF).

9. Dispositif de communication selon la revendication 1, dans lequel ledit signal d'entrée du premier élément et ledit signal d'entrée du second élément sont des signaux similaires.

10. Dispositif de communication selon la revendication 1, dans lequel ledit premier élément et ledit second élément sont des éléments de la bande Ka, la bande Ku, la bande S ou la bande C.

11. Dispositif de communication selon la revendication 1, dans lequel le combinateur à guide d'ondes est un combinateur à guide d'ondes de type T magique.

12. Dispositif de communication selon la revendication 1, qui comprend en outre un duplexeur de polarisation (OMT) relié au moins audit premier élément et audit second élément ou au combinateur à guide d'ondes, dans lequel ledit OMT est configuré pour :
- recevoir un signal de communication depuis une antenne et transmettre ledit signal reçu au moins audit premier élément ou audit second élément, et
- recevoir ledit signal de communication combiné depuis ledit combinateur à guide d'ondes et transmettre ledit signal de communication combiné à ladite antenne.

13. Procédé d'amplification de signal de communication, **caractérisé en ce que** le procédé comprend des étapes de :
- séparation (910) d'un premier signal de communication, dans laquelle ledit premier signal de communication séparé comprend un second signal de communication et un troisième signal de communication dans lesquels le second signal de communication et le troisième signal de communication sont de même fréquence ;
- communication (920) dudit second signal de communication à un premier émetteur récepteur ou à un premier émetteur ;
- communication (920) du troisième signal de communication à un second émetteur récepteur ou un second émetteur ;
- conversion élévation de fréquence et amplification (940) dudit second signal de communication en utilisant ledit premier émetteur récepteur ou ledit premier émetteur pour créer un premier signal de communication amplifié ;
- conversion à élévation de fréquence et amplification (940) dudit troisième signal de communication en utilisant le second émetteur récepteur ou le second émetteur pour créer un second signal de communication amplifié ; et
- combinaison (950) dudit premier signal de communication amplifié et dudit second signal de communication amplifié.

14. Procédé selon la revendication 13, dans lequel l'amplification du second signal de communication utilisant le premier émetteur récepteur ou le premier récepteur comporte les étapes de :
- communication dudit second signal de communication à un premier convertisseur élévateur de fréquence (BUC) contenu dans ledit premier émetteur récepteur ou ledit premier émetteur ;
- amplification dudit troisième signal de communication en utilisant ledit second émetteur récepteur ou ledit second émetteur ; et
- communication dudit troisième signal de communication à un second BUC contenu dans le second émetteur récepteur ou le second émetteur.

15. Procédé selon la revendication 13 dans lequel la table de combinaison délivre un signal de communication de haute fréquence et haute puissance.

16. Procédé selon la revendication 15 comprenant donc une étape de communication dudit signal de communication à haute puissance à un dispositif de communication externe et/ou de communication dudit signal de haute fréquence à un dispositif de communication externe.
